# FASCICULE DE BREVET EUROPEEN

(11) **EP 1 700 256 B1**
(45) Date de publication et mention de la délivrance du brevet: **15.08.2007**
(21) Numéro de dépôt: 04816603.7
(22) Date de dépôt: 23.12.2004
(51) Int. Cl.: G06K 19/077, H01L 23/58

(54) **PROTECTION D'UNE PUCE DE CIRCUIT INTÉGRÉ CONTENANT DES DONNÉES CONFIDENTIELLES**
SCHUTZ FÜR EINEN INTEGRIERTEN SCHALTUNGSCHIP, DER VERTRAULICHE DATEN ENTHÄLT
PROTECTION FOR AN INTEGRATED CIRCUIT CHIP CONTAINING CONFIDENTIAL DATA

(30) Priorité: 29.12.2003 FR 0351221
(43) Date de publication de la demande: 13.09.2006
(73) Titulaire: COMMISSARIAT A L'ENERGIE ATOMIQUE, 75015 Paris (FR)
(72) Inventeur: SAVRY, Olivier, F-38360 Sassenage (FR); BILLARD, Christophe, F-38140 Renage (FR)
(74) Mandataire: Poulin, Gérard
(86) Numéro de dépôt international: PCT/FR2004/050756
(87) Numéro de publication internationale: WO 2005/069210

(56) Documents cités:
- EP-A- 0 874 401
- DE-A- 19 738 990
- US-A- 4 933 898
- US-A- 5 861 662
- US-A1- 2002 008 428
- US-B1- 6 246 970
- KOEMMERLING O ET AL: "DESIGN PRINCIPLES FOR TAMPER-RESISTANT SMARTCARD PROCESSORS" USENIX WORKSHOP ON SMARTCARD TECHNOLOGY, XX, XX, 10 mai 1999 (1999-05-10), pages 9-20, XP009010824 cité dans la demande

## Description

### DOMAINE TECHNIQUE ET ART ANTERIEUR

La présente invention concerne la protection des circuits intégrés électroniques et porte plus particulièrement sur des moyens pour empêcher l'accès à des contenus sensibles à la sécurité, tels que des données d'informations confidentielles, des codes de cryptage ou de décodage, des programmes ou des données secrètes, ou même simplement des données objet de propriété à protéger, stockées en mémoire de circuits intégrés.

L'invention s'adresse particulièrement à la sécurisation des circuits intégrés à mémoire, à microprocesseur ou à microcontrôleurs (y compris les circuits intégrés à application spécifique dits ASIC) qui sont utilisés par exemple, dans les domaines des cartes à puces, des transactions de paiement électronique, des distributeurs de billets, des dispositifs de porte-monnaie électronique, le domaine du cryptage/décodage de signaux audiovisuels de télévision à péage, le domaine des téléphones mobiles, le domaine des système d'accès sécurisés ou d'identification comme les cartes de santé et les dispositifs analogues.

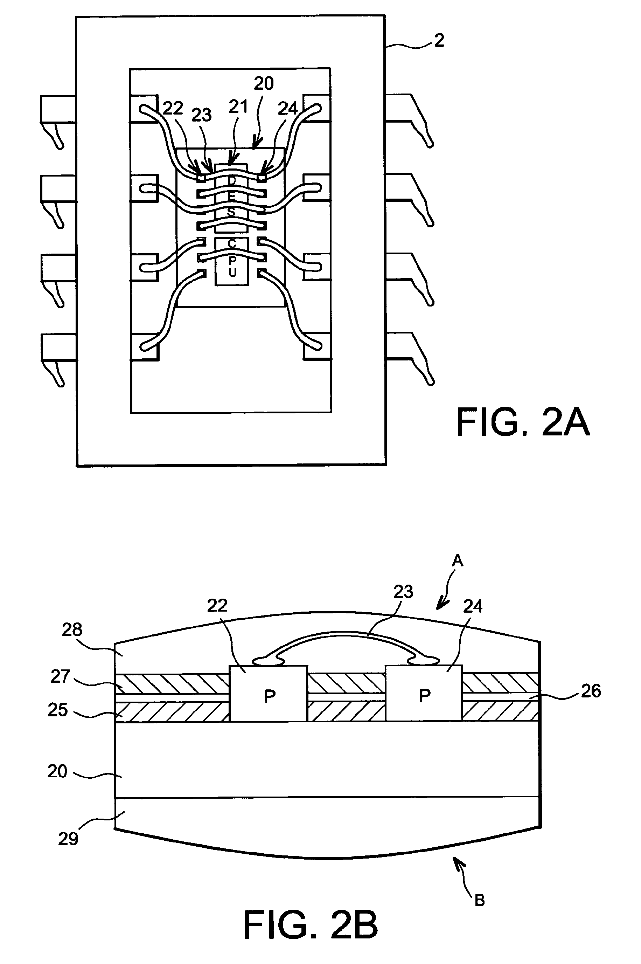

Pour accéder aux données protégées dans les circuits intégrés, les personnes non autorisées, connues sous le nom de « pirates », disposent de plusieurs méthodes d'investigation. Les pirates commencent généralement par désencapsuler le circuit intégré en enlevant le matériau du boîtier du composant 2, comme suggéré sur la figure 2A, pour accéder à la puce de substrat 20 du circuit intégré proprement dit.

Les éléments 21 du circuit intégré qui stockent, transmettent et traitent les données secrètes sont implantés sur la surface supérieure du substrat 20 qui est recouverte de plusieurs couches successives de revêtement, tels que des couches de passivation du substrat, de métallisation de circuiterie et d'isolation.

Les pirates cherchent à enlever les couches de revêtement par ablation mécanique, par attaque chimique, par dissolution acide, par découpage laser, par attaque de type communément appelé DFA (abréviation de « Differantial Fault Analysis ») pour accéder aux pistes du circuit et à la topographie du circuit électronique, de façon à dériver les signaux de données ou percer le fonctionnement du circuit.

Plusieurs méthodes peuvent permettre aux pirates d'accéder aux données. Ils peuvent utiliser des sondes de contacts microscopiques pour repiquer les signaux échangés sur les bus (éventuellement en perçant des trous), ou à l'aide de sondes électromagnétiques sans contact ou en utilisant un dispositif de microscopes optiques confocaux pour révéler le schéma électronique du circuit intégré, ou en utilisant une station de travail à faisceau d'ions focalisé (FIB) pour décaper très finement les matériaux de revêtement, métaux ou isolants, et recomposer la structure du circuit (topographie) avec une très haute résolution.

Une autre méthode consiste à utiliser un dispositif perfectionné de microscope à balayage électronique (SEM), qui permet de révéler les potentiels électriques des signaux échangés dans les puces, la mesure étant faite sans contact au travers de la puce.

A l'heure actuelle, on connaît des dispositifs destinés à protéger la puce contre ces intrusions par la face avant.

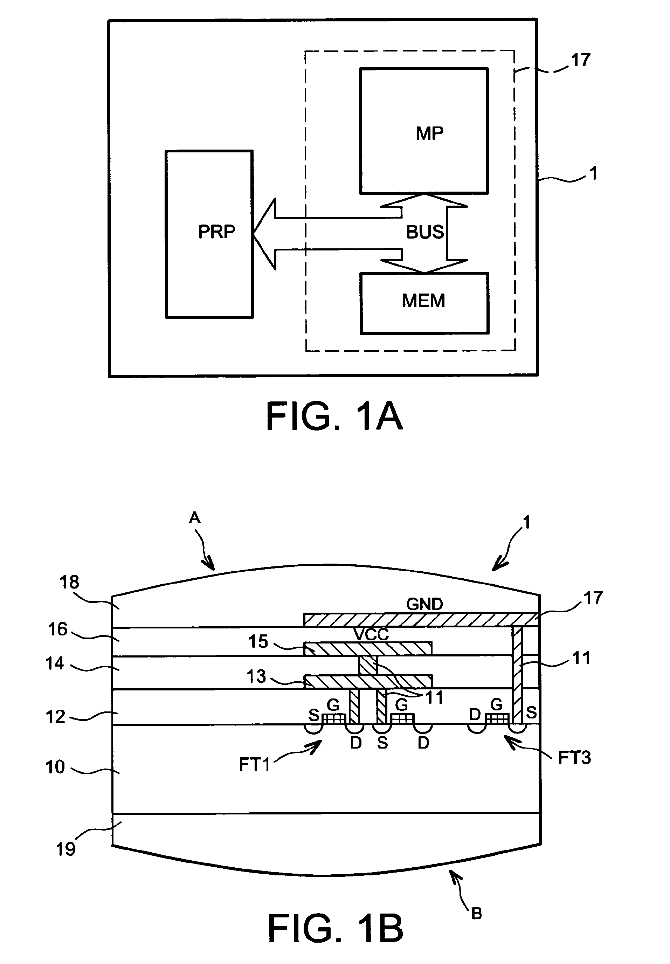

Le document US-4 933 898 décrit une puce de circuit intégré sécurisé par une carapace de protection conductrice disposée sur la face avant de la puce, comme schématisé sur les figures 1A et 1B annexées ci-après.

La vue en coupe de la figure 1B montre que la structure du composant 1 de circuit intégré comporte des plans métallisés 13,15,17 formant des écrans aménagés dans des couches supérieures 12,14,16 déposées sur le substrat 10 du circuit intégré 1.

Selon l'enseignement du document US 4 933 898, ces écrans recouvrent des zones sensibles 17 correspondant aux circuits MP,BUS,MEM à transistors FT1,...,FT3 qui contiennent les données à protéger (mémoire MEM, bus de transmission BUS, unité de traitement MP, par exemple). Chaque écran 13, 15 ou 17 est relié, par l'intermédiaire de trous métallisés 11 (via) traversant les couches supérieures 12-14-16 aux circuits à transistors FT1,...,FT3 et conduit un signal d'alimentation VCC ou GND nécessaire au fonctionnement ce ces circuits. Cette carapace métallique a pour fonction d'une part, d'empêcher une analyse au microscope à balayage électronique (SEM), aux rayons X ou par d'autres moyens électromagnétiques à travers la puce 1 et d'autre part, en cas d'intrusion ou d'ablation mécanique d'un tel écran conducteur 17, 15 ou 13, de provoquer une coupure d'alimentation des circuits à transistors détruisant automatiquement les données secrètes.

L'inconvénient d'un tel dispositif est que seule la face avant est protégée contre des intrusions ou des attaques destinées à percer la confidentialité des données sauvegardées. La face arrière 19,B reste accessible à une analyse ou à une attaque d'un pirate pour accéder aux données protégées.

Le document US-5 861 662 décrit un autre système de protection anti-piratage d'un circuit intégré 2, illustré sur les figures 2A et 2B annexées.

Des fils de liaison (en anglais, « wire bonds ») 23 s'étendent au dessus des circuits sécurisés 21 traitant les données à sauvegarder (tels qu'une unité de calcul CPU, un circuit périphérique DES de standard d'encryptage de données, une mémoire de type RAM, ROM ou autre). Les fils 23 sont noyés dans la masse du matériau d'encapsulation 28, constitué d'une couche d'époxy 28, qui recouvre les zones d'implantation de ces circuits électroniques sensibles 21. Les fils de liaison 23 transmettent les signaux nécessaires au fonctionnement de ces circuits actifs 21 et sont reliés audits circuits 21 par l'intermédiaire de plots P constitués par des trous métallisés 22,24 (via) traversant les couches de vitrification 25, de métallisation 26 et de passivation 27 qui recouvrent successivement le substrat semi-conducteur 20 et séparent la puce du matériau d'enrobage 28 à l'intérieur du boîtier du composant 2.

La couche de métallisation 26 intégrée dans les couches de protection 25 à 27 recouvrant le substrat 20 forme, là encore, un écran à l'analyse au microscope à balayage électronique (SEM).

La puce 20 du circuit intégré se présente alors incluse dans le matériau d'encapsulation qui forme une couche supérieure d'époxy 28 comportant le filet de fils de protection et une couche inférieure d'époxy 29 inerte. La puce 20 est finalement reportée dans le boîtier externe du composant 2 et reliée aux pattes de connexion (« pads/pins »).

L'inconvénient ici est encore que seule la face avant A, c'est-à-dire le côté supérieur de la puce 20, est protégée contre des intrusions ou attaques pirates.

Aucune protection n'est prévue en face arrière 29-B.

Les seules dispositions adoptées en général concernant la face arrière B des puces de circuit intégré contenant des données confidentielles consistent à envelopper totalement la puce dans un matériau d'encapsulation 29 difficile à enlever. Mais les pirates sont en mesure d'attaquer aisément ces matériaux d'encapsulation. En effet, les pirates reportent maintenant les attaques sur la face arrière suite aux dispositions de protection de la face avant prises par les constructeurs de circuits intégrés, notamment pour les cartes à puce. Les méthodes utilisées par les pirates pour l'attaque de la face arrière sont classiquement des attaques DFA, découpe laser, analyse électromagnétique en général, etc....

La communication de R. Anderson et M. Kuhn, intitulée « Tamper resistant - a cautionary note », publiée dans le « second USENIX Workshop on Electronic Commerce Proceedings » (page 1 à 11) en novembre 1996, décrit la plupart des méthodes d'attaques pirates connues actuellement.

L'inconvénient de ces dispositifs connus est de ne disposer d'aucune protection en face arrière.

Le document US-2002/0008428A1 divulgue un dispositif électronique comportant une puce de circuit intégré destiné à contenir ou traiter des données d'information à protéger de manière sécurisée. De plus, ce document décrit une antenne en forme d'un premier élément conducteur qui est disposé sur un premier côté de la puce. Un autre élément conducteur de la même antenne se trouve sur un autre côté de la puce. Étant donné que le premier élément conducteur et l'autre élément conducteur sont des éléments de la même antenne, ils sont couplés électriquement par liaison galvanique. De plus, selon les lois de l'électrodynamique, les deux parties de l'antenne sont couplées électromagnétiquement.

L'objet de l'invention est de réaliser des circuits intégrés remédiant aux inconvénients précédents.

Un objectif de l'invention est de fournir une protection de la face arrière des puces de circuit intégré dont la sécurité est sensible.

Un autre objectif de l'invention est d'améliorer en général la protection d'un circuit intégré contenant des données secrètes, aussi bien sur la face arrière que sur la face avant.

L'objectif en particulier est de protéger un circuit intégré contenant des données sensibles contre toutes sortes d'attaques pirates sur les deux faces opposées de la puce, tels que les attaques lasers, les inspections électromagnétiques sans contact, les analyses au microscope à balayage électronique (SEM), ou avec des microscopes confocaux, les attaques DFA, les intrusions par décapage mécanique ou chimique, les intrusions par microsondes, les analyses chimiques (avec révélateurs cristallographiques ou ioniques), la résolution structurelle à l'aide d'un dispositif à faisceau d'ions focalisé (FIB), etc....

Un autre objectif est d'obtenir un circuit intégré disposant d'une protection complète des faces dont la mise en oeuvre soit simple, en particulier n'impliquant pas la fabrication de via à travers toute l'épaisseur de la puce.

### EXPOSÉ DE L'INVENTION

Ces objectifs sont atteints en prévoyant selon l'invention, qu'un circuit intégré contenant des informations sensibles dispose d'une protection complète comportant un premier élément conducteur disposé côté supérieur ou au niveau d'une première face, par exemple la face avant de la puce du circuit intégré et formant une inductance superficielle, associé avec un autre élément métallique ou conducteur en général, disposé côté inférieur ou au niveau d'une seconde face, par exemple la face arrière de la puce, cet autre élément superficiel modifiant le champ et/ou la valeur de l'inductance, de sorte que toute variation de l'inductance provoquée par une attaque et/ou une atteinte, et/ou une intrusion de l'élément inductif en face arrière ou une attaque (atteinte/intrusion) de l'inductance elle-même en face avant soit détectée par le circuit intégré, lequel dispose de moyens pour déclencher des contre-mesures, comme l'effacement des informations codées ou des données sauvegardées en mémoire.

Le dispositif de protection selon l'invention peut être formé simplement d'une spirale ou d'un serpentin d'inductance métallisée, déposée sur ou dans un plan superficiel, côté supérieur de la puce et couplée avec un plan métallisé disposé sur ou sous la surface arrière côté inférieur de la puce, ce plan pouvant former par exemple un réflecteur électromagnétique.

Il est prévu que l'élément conducteur de l'inductance est relié aux pistes et aux transistors du circuit électronique, dont elle est séparée par une couche de passivation, par l'intermédiaire de trous métallisés (via) traversant cette passivation.

Par contre, l'élément conducteur de la face arrière étant couplé sans contact à l'inductance de la face avant, il n'est pas nécessaire de le relier au circuit intégré de la puce, et la face arrière ne comporte aucun via de connexion. En effet, l'invention permet avantageusement d'éviter d'aménager un trou métallisé (via) à travers l'épaisseur du substrat semi-conducteur, ce qui poserait un problème techniquement.

Ainsi, de façon avantageuse, la face arrière de la puce est protégée sans aménager de trou métallisé à travers la puce de substrat. Une métallisation pleine plaque de la face arrière est suffisante pour parachever la protection de la puce en face arrière.

L'invention met en oeuvre un dispositif électronique comprenant une puce de circuit intégré destiné à contenir, notamment stocker, mémoriser, transmettre ou traiter, des données d'information à protéger de manière sécurisée, comme des données secrètes, des données de cryptage ou de décodage, dans lequel un premier côté de la puce comporte au moins un premier élément conducteur et en ce qu'un autre côté de la puce comporte un autre élément conducteur.

Le premier élément conducteur et l'autre élément conducteur peuvent être couplés.

Selon une mise en oeuvre, le premier côté de la puce peut comporter, en outre, un deuxième élément conducteur disposé à proximité du premier élément conducteur.

Selon l'invention, le premier élément conducteur et/ou le deuxième élément conducteur peut comporter une inductance, tandis que l'autre élément conducteur peut former un plan de masse à faible résistance et/ou comporter une conductance.

Selon l'invention, le circuit électronique intégré sur ou dans la puce peut comporter des moyens d'excitation électromagnétique du premier élément conducteur.

Il peut être prévu aussi que le circuit électronique intégré comporte des moyens de mesure de l'inductance d'au moins un des éléments conducteurs.

Le circuit intégré peut comporter encore des moyens de détection d'un changement de valeur d'au moins un paramètre électrique du ou des éléments conducteurs, notamment un changement de valeur d'inductance ou de résistance du premier et/ou du deuxième élément conducteur.

Et, il peut être prévu que le circuit intégré comporte des moyens pour effacer ou cesser de stocker les données d'information en cas de détection de changement de valeur de paramètre électrique.

Avantageusement, le premier élément conducteur et/ou le deuxième élément conducteur peut être relié au circuit électronique intégré de la puce par l'intermédiaire d'au moins et/ou au moins d'une connexion également appelée « via » traversant une ou des couches de revêtement recouvrant le premier côté de la puce, tandis que l'autre côté ne comporte pas de via ou de connexion.

Pour finir, les éléments conducteurs de la puce sont recouverts d'un matériau d'encapsulation.

L'invention peut être mise en oeuvre notamment dans une carte à puce, comprenant au moins un tel dispositif électronique de puce de circuit intégré.

L'invention peut également s'appliquer à un dispositif de cryptage ou de décodage, comprenant un ou plusieurs de tels dispositifs électroniques de puce de circuit intégré.

### BRÈVE DESCRIPTION DES DESSINS

D'autres objectifs, caractéristiques et avantages de l'invention apparaîtront à la lecture de la description détaillée ci-après, de modes de réalisation de l'invention, faite à titre d'exemple non limitatif, en regard des dessins annexés sur lesquels :
- les figures 1A et 1B représentent, vue de dessus et en coupe, une puce de circuit intégré avec une protection en face avant, selon l'état de la technique ;
- les figures 2A et 2B représentent, vue de dessus et en coupe, une puce de circuit intégré comportant des fils de protection en face avant, selon l'état de la technique ;
- les figures 3A et 3B représentent, en vue plongeante et en coupe, une puce de circuit intégré avec des éléments conducteurs de protection en face avant et en face arrière, selon l'invention ;
- la figure 4 représente une vue de dessus de l'implantation de deux éléments conducteurs en face avant d'une puce de circuit intégré selon l'invention ;
- la figure 5 représente une vue en coupe de niveaux d'interconnexion entre les éléments conducteurs en face avant et la puce de circuit intégré, selon l'invention ;
- les figures 6A et 6B représentent un mode de réalisation d'enroulement conducteur sur une puce de circuit intégré, selon l'invention ; et,
- les figures 7A et 7B représentent un autre mode de réalisation d'élément conducteur sur une puce de circuit intégré, selon l'invention.

### EXPOSÉ DÉTAILLÉ DE MODES DE RÉALISATION DE L'INVENTION

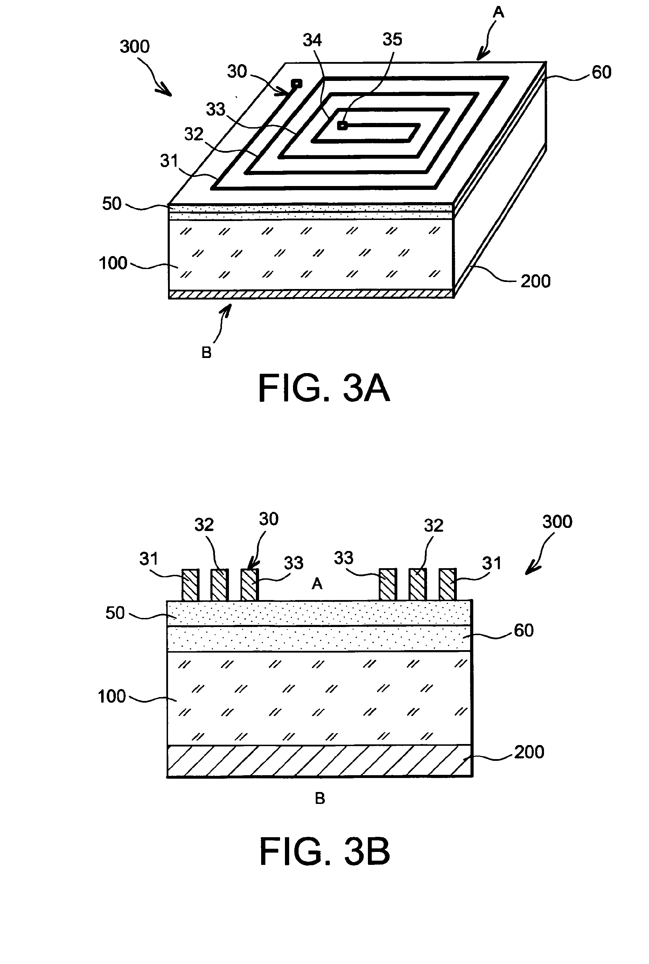

Les figures 3A et 3B schématisent un premier mode de réalisation d'un circuit intégré sécurisé 300 qui illustre le principe de l'invention.

Sur les figures, la puce de circuit intégré 300 est représentée nue, sous une forme dépouillée, hors de tout matériau d'encapsulation ou d'enrobage et sans patte de connexion, éléments qui peuvent constituer les éléments extérieurs du boîtier d'un composant électronique achevé.

Le coeur du circuit intégré 300 est formé d'une puce de substrat 100 dans lequel sont implantés les éléments du circuit électronique, tels que les transistors, diodes, résistances, condensateurs etc..., qui ne sont pas représentés ici.

La puce 300 est constituée d'un petit morceau de matériau semi-conducteur généralement parallélépipédique et de dimensions miniatures (de l'ordre de quelques micromètres à plusieurs dizaines de millimètres, voire plus, typiquement entre une centaine de micromètres et plusieurs micromètres, généralement une fraction de micromètre ou quelques micromètres, par exemple : 0,25 micron ou 1,3 micron de côté pour 0,15 micron d'épaisseur environ).

Selon l'invention, la puce de circuit intégré 300 comporte un premier élément conducteur 30 disposé sur ou dans le côté supérieur de la puce 300 correspondant à la face avant A, par exemple sur une première couche 50 de passivation, pouvant elle-même reposer sur une deuxième couche 60 de passivation. La puce comporte d'autre part un autre élément conducteur 200 disposé en face arrière B, côté inférieur de la puce 300.

Dans cette configuration, la disposition des éléments conducteurs sur les faces opposées A et B de la puce 300 permet d'obtenir un couplage, de nature inductive ou électromagnétique, entre le premier élément conducteur 30 et l'autre élément conducteur 200.

Selon le mode de réalisation de la figure 3A, le premier élément conducteur 30 comporte un enroulement spiral inducteur à plusieurs spires 31, 32,33,34 et forme en quelque sorte un bobinage de self ou une bobine d'inductance. Suivant le schéma 3A, l'autre élément conducteur 200 est formé d'un plan métallique déposé sur la surface arrière B de la puce 300. Sur la figure 3B seules 3 spires 31, 32, 33 sont représentées.

Dans la configuration de la figure 3A, l'autre élément conducteur 200 est déposé à faible distance du premier élément conducteur 30 et dans l'axe ou du moins auprès de l'axe A-B des spires de la bobine d'inductance formée par le premier élément 30, si bien que l'autre élément conducteur 200 se trouve géométriquement dans le champ du premier élément 30.

L'interposition de l'autre élément conducteur 200 dans le champ du bobinage d'inductance du premier élément conducteur 30 modifie la valeur d'inductance de ce premier élément 30.

Une telle disposition permet avantageusement de protéger la face arrière B du circuit intégré 300. Elle confère plusieurs niveaux de protection.

D'une part, l'élément conducteur 200 en face arrière offre une protection passive. La métallisation de la face arrière forme une barrière mécanique et un écran aux ondes électromagnétiques et aux particules.

Ainsi, l'élément conducteur 200 en face arrière protège contre les intrusions mécaniques et empêche de disposer une sonde électromagnétique pour capter les signaux sans contact.

L'élément 200 forme, en outre, un écran contre les rayons X et contre un faisceau d'électrons d'un microscope à balayage électronique (SEM).

L'élément conducteur 200 en face arrière offre ainsi une protection passive contre les attaques de pirates cherchant à percer l'accès aux données secrètes par le biais de tels moyens de visualisation ou d'investigation.

L'invention permet d'autre part une protection active en cas de tentative d'escamoter totalement ou partiellement la métallisation 200 de la face arrière B.

En effet, puisque l'inductance du premier élément conducteur 30 est modifiée par l'interposition de l'autre élément conducteur 200 dans son champ, l'ablation de cet autre élément 200 aura pour conséquence de faire varier la valeur de l'inductance du premier élément 30.

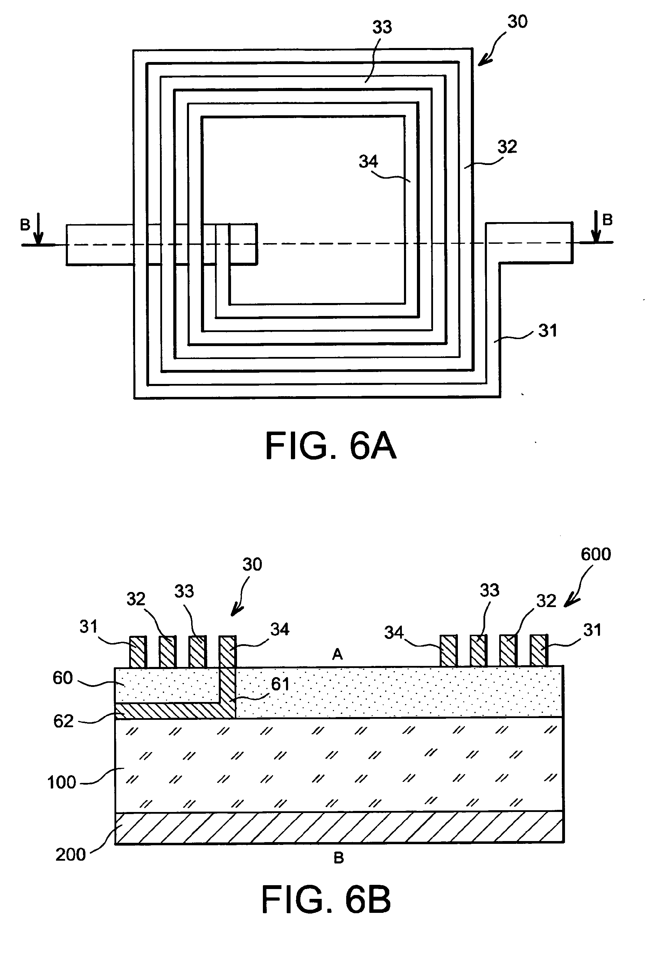

Ainsi, suivant l'exemple de réalisation des figures 6A et 6B, en déposant une structure formée d'une couche de revêtement 60 en oxyde ou en dioxyde de silicium sur laquelle est implantée une piste 30 en cuivre de dix micromètres de largeur (10 µm) enroulée en forme de grecque ou de spirale carrée à quatre spires 31,32,33,34 et en déposant une métallisation 200 de plan de masse en aluminium de cinq micromètres d'épaisseur (5 µm) de l'autre côté B d'une puce 100 carrée de deux cent cinquante micromètres de côté (250 µm) et de cent cinquante micromètres d'épaisseur (150 µm) en substrat de silicium (semi-conducteur de résistivité de quinze ohms centimètres) on obtient une variation de valeur d'inductance de l'ordre de un dixième (environ 10 %) en cas d'ablation du plan métallisé 200 en face arrière B. La référence 61 désigne un via et la référence 62 une couche de métallisation.

La puce a une taille ou une surface sensiblement comprise entre 3x3 mm² et 5x5 mm².

Une amplitude telle que mentionnée ci-dessus est suffisante pour que le circuit électronique puisse détecter une intrusion et déclencher des mesures contre le piratage consistant par exemple à effacer les données confidentielles ou à bloquer leur accès en lecture.

Par suite, l'invention dispose de moyens de protection active consistant à mesurer, constamment ou par intermittence, la valeur d'inductance du premier élément conducteur 30 en face avant.

De façon avantageuse, l'invention permet de vérifier l'intégrité du dispositif de protection 200 en face arrière par l'intermédiaire du premier élément conducteur 30 en face avant, ceci à distance et sans contact avec l'élément conducteur 200 en face arrière.

L'invention permet encore de protéger la face avant A contre les attaques pirates grâce au premier élément 30 disposé côté supérieur A de la puce.

Une tentative d'ablation d'une partie ou de la totalité des couches de passivation 50, 60 recouvrant le substrat 100 et le circuit électronique intégré se soldera par l'ablation ou le court-circuit des spires du premier élément conducteur 30, donc par une détection de disparition ou de variation de l'inductance. D'autre part, une tentative d'intrusion consistant à insérer une microsonde pour repiquer les signaux échangés sur les pistes de connexion du circuit intégré 300, se soldera par la coupure ou le court-circuit des pistes 31, 32, 33, 34 de l'élément conducteur 30, ce qui modifie la valeur d'inductance ou de résistance, ou plus généralement l'impédance du premier élément conducteur 30.

En outre, selon un autre mode de réalisation de l'invention, il est prévu de perfectionner la protection en disposant un deuxième élément conducteur 40 à proximité du premier élément conducteur 30 en face avant A, à la surface ou à l'intérieur (sous la surface) du premier côté de la puce.

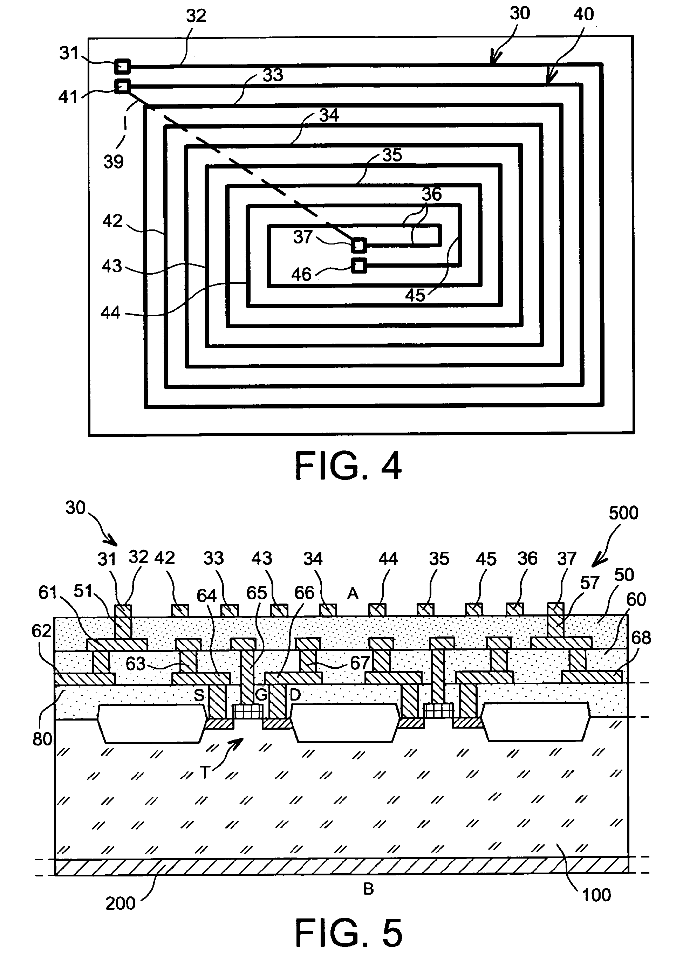

La figure 4 montre un schéma d'implantation de deux éléments conducteurs 30,40 côté supérieur d'une puce de circuit intégré, selon cet autre mode de réalisation de l'invention.

Sur l'exemple de réalisation de la figure 4, le premier et le deuxième éléments conducteurs 30,40 sont constitués de deux bobines d'inductances formées par deux enroulements de pistes métalliques disposées en spirale de manière alternée et imbriquée l'une dans l'autre.

Avantageusement, les deux enroulements 30 et 40 sont reliés en série par une jonction sous-jacente 39, tel qu'un 'pont' ou un passage conducteur (en anglais « underpass ») si bien que leurs inductances s'ajoutent.

Ainsi, toute tentative d'intrusion amenant la coupure d'une piste de self-inductance 32-36, 41-44 ou un court-circuit entre les deux éléments conducteurs 30 et 40, se traduit par une modification de la valeur d'inductance totale des éléments conducteurs. Il suffit donc de mesurer constamment ou par intervalles de temps (réguliers ou irréguliers) la valeur d'inductance de l'ensemble des éléments 30 et 40 en série entre les connexions 31 et 46, pour détecter une intrusion dans le circuit intégré.

Selon l'invention, le circuit intégré comporte donc des circuits électroniques internes constituant des moyens d'excitation électromagnétique du premier élément conducteur 30, des moyens pour mesurer l'inductance de l'ensemble conducteur 30/40, et des moyens pour détecter un changement de valeur de l'inductance.

En cas de détection de changement de valeur d'un paramètre électrique, signifiant une violation du dispositif de protection, le circuit intégré active des mesures de protection contre l'intrusion consistant par exemple, à effacer les données secrètes, à bloquer le fonctionnement du circuit ou à interdire une transmission de données, notamment en sortie.

Des moyens d'excitation de l'inductance peuvent être des moyens générateurs d'un courant sinusoïdal, appliqué à l'inductance.

On peut alors remesurer, au choix, une variation de phase ou d'amplitude de cette sinusoïde, entre la tension aux bornes et le courant injecté, et ce à l'aide de moyens de mesure de variation, respectivement de phase ou d'amplitude.

Il est également possible de mesurer la fréquence de résonance d'un circuit constitué de l'inductance couplée avec un, ou des, composants de type R et/ou C ayant des valeurs connues. Dans ce cas, des moyens de mesure de résonance, ou de mesure de fréquence, sont mis en oeuvre.

Des moyens d'excitation de l'inductance peuvent également être des moyens pour générer un signal rectangulaire, attaquant un circuit constitué de l'inductance, en série ou en parallèle avec une résistance déterminée.

Il est alors possible de mesurer, avec des moyens appropriés, une variation de temps de montée, ou de temps de descente, du signal.

Dans tous les cas, le signal mesuré peut se présenter sous la forme d'une tension dépendante de l'inductance. On cherche alors à comparer cette tension, image de l'inductance, avec une tension mémorisée qui fait office de référence. Une telle mémorisation dans le circuit peut être faite, dans des moyens de mémorisation, de façon analogique (par exemple par stockage dans une capacité) ou numérique (la référence étant stockée dans une mémoire ROM au format binaire, et convertie par un CNA en tension analogique).

La comparaison entre la mesure et la valeur stockée s'effectue alors à l'aide de moyens comparateurs de tension.

Si ces deux valeurs sont trop différentes, on peut appliquer des contre mesures, consistant par exemple à arrêter l'alimentation de la puce (par exemple par un transistor entre la masse et le VCC), ou effacer la mémoire (plusieurs techniques pouvant être envisagées selon le type de mémoire utilisée), ou bloquer un élément vital du microprocesseur (par exemple l'accès à la pile, ou au registre,...).

Comme illustré figure 5, il est prévu de relier les circuits électroniques internes de la puce 500 avec le premier élément conducteur 30 et, le cas échéant, avec le deuxième élément conducteur 40, de façon à appliquer un courant inductif dans la bobine d'inductance 30 afin d'obtenir une excitation électromagnétique et de façon à effectuer les mesures électriques aux bornes des éléments conducteurs 30 et 40.

La figure 5 représente une vue en coupe d'une réalisation d'une puce de circuit intégré 500 qui fait apparaître un mode de connexion entre les éléments conducteurs 30 et 40 disposés par-dessus les couches d'isolation/métallisation/passivation successives de la puce de circuit intégré (éléments conducteurs supra puce) et les circuits électroniques internes de la puce 500. Les circuits internes de la puce de circuit intégré (non illustré en détail) contiennent les moyens d'excitation électromagnétique du premier élément conducteur 30, les moyens de mesure de paramètres électriques du premier et/ou du deuxième élément conducteur 30/40 ainsi qu'éventuellement les moyens de détection de changement de valeur de paramètre électrique.

De façon avantageuse, il est prévu de relier le premier élément conducteur 30 au circuit électronique interne d'excitation et de mesure de paramètre électrique, par l'intermédiaire d'au moins un via, c'est-à-dire d'un trou aménagé au travers des couches de passivation/isolation 50/60/80 et rempli d'un dépôt métallique pour ramener le contact électrique à la surface.

L'exemple schématique de la figure 5 montre ainsi que des transistors T de commande aptes à délivrer un signal commuté ou un signal alternatif d'excitation à la bobine d'inductance 30, peuvent être reliés aux plages de connexions d'extrémité 31 et 37 du premier élément conducteur 30 par l'intermédiaire de plusieurs niveaux successifs de métallisation 62-52, 68-58 et de via d'interconnexion 61-51, 69-57 aménagés dans l'épaisseur des couches de revêtement 50-60-80 déposées au dessus du substrat 100 du circuit intégré de la puce 500.

Initialement, le substrat comporte par exemple des zones de diffusion ou d'implantation ionique d'éléments dopants formant des canaux de transistors à effet de champ de type MOSFET séparés par des caissons d'isolation en oxyde de type FOX.

Chaque transistor T comporte des métallisations de contact de source S, de grille G et de drain D, tous ces éléments étant recouverts d'une couche de passivation 80.

Chaque borne de contact S,G,D est surmontée d'un via, c'est-à-dire d'un trou métallisé traversant l'épaisseur de la couche de passivation 80, pour ramener le contact à la surface de la passivation.

Une couche de métallisation 62-64-66-68 est déposée et gravée sur la couche de passivation 80 pour former des pistes métallisées, matérialisant la topographie du circuit électronique proprement dit, c'est-à-dire les chemins du circuit d'interconnexion entre les bornes de contact des transistors T et celles des autres éléments composant le circuit.

Ce niveau de pistes métallisées d'interconnexion 62-64-66-68 est recouvert d'une couche 60 de revêtement isolant supplémentaire pour isoler et protéger les pistes du circuit.

Selon le mode de réalisation de la figure 5, des vias 61,63,65,67,69 sont aménagés à travers cette couche 60 pour ramener le contact des bornes de commandes S,G,D en connexion avec les bornes 31 et 37 des éléments conducteurs 30 et 40.

Un autre étage comportant un niveau de pistes métallisées 52-58 recouvert d'une couche de revêtement 50 peut encore être prévu au-dessus de cette structure étagée 60/80 pour réaliser une ou des interconnexions entre les bornes 31-37 et 41-46 des bobines d'inductances formées par le premier et le deuxième éléments conducteurs 30 et 40.

Comme schématisé figure 4, une telle disposition permet avantageusement de relier en série l'enroulement spiral du premier élément conducteur 30 avec l'enroulement spiral du deuxième élément conducteur 40, par l'intermédiaire d'une interconnexion 39 ou d'une jonction sous-jacente aménagée à l'intérieur de la couche 50 sur laquelle les pistes métalliques 31 à 37 et 41 à 46 des éléments conducteurs 30 et 40, sont elles même déposées.

Une telle interconnexion (en anglais « underpass ») comportant au moins un premier via 57 (69), une piste conductrice sous-jacente 39 (ou 58-69-68-...-62-61-52) et au moins un deuxième via 51 (61), permet de relier en série l'extrémité finale 37 du premier enroulement conducteur 30 à l'extrémité initiale 41 de l'autre enroulement conducteur 40. Ainsi on peut avantageusement relier en série les deux enroulements 30 et 40 imbriqués l'un dans l'autre sans inverser le sens de rotation du courant d'induction.

De tels vias et niveaux d'interconnexion permettent d'autre part de relier les bornes 31,41,37,46 des éléments conducteurs au circuit électronique interne de la puce, en particulier aux bornes des moyens d'excitation et des moyens de mesure de paramètres électriques.

Selon le processus de réalisation prévu par l'invention, le premier élément conducteur et/ou le deuxième élément conducteur sont implantés par dépôt de métallisation et gravure sur le premier côté de la puce, le dépôt des métallisations du premier et/ou du deuxième élément conducteur étant précédé par des étapes de dépôt de couches de passivation, de métallisation et de gravure pour former au moins un niveau conducteur d'interconnexion intermédiaire entre le circuit électronique intégré et le ou les éléments conducteurs.

Le processus de réalisation prévoit encore que l'autre élément conducteur est formé par dépôt de métallisation sur l'autre côté de la puce.

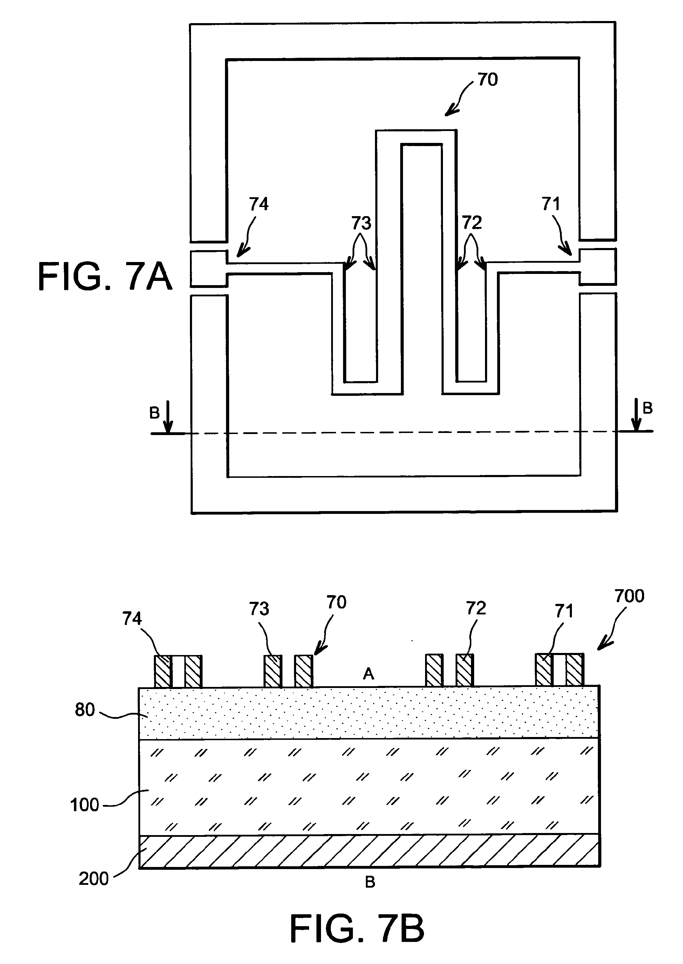

Les figures 7A et 7B montrent un autre mode de réalisation permettant de supprimer une couche et un niveau d'interconnexion (« underpass ») entre les bornes du ou des éléments conducteurs 50 implantés côté supérieur en face avant, et d'éviter d'aménager un via d'interconnexion à ce niveau.

Selon le mode de réalisation de la figure 7A, le premier élément conducteur 70 est formé par un serpentin 71 à 74 comportant au moins un méandre 72, 73, constitué de tronçons de pistes métalliques sensiblement parallèles ici et interconnectés en alternance, suivant un chemin analogue au trajet d'aller-retour de navette d'un fil de trame.

Les méandres 72 et 73 du serpentin produisent un champ de nature inductive ou électromagnétique dans l'axe A-B transversal au plan du serpentin 70, champ dans lequel vient s'interposer l'autre élément conducteur 200 de l'autre face B de la puce, ce qui modifie la valeur d'inductance du serpentin du premier élément 70, selon le principe de l'invention.

Suivant l'exemple de réalisation des figures 7A et 7B, en implantant une telle piste métallique en serpentin 70 en aluminium de cinq micromètres d'épaisseur (5 µm) pour former le premier élément conducteur sur une puce 100 de substrat (ou sur une couche 80 de passivation la recouvrant) de un et demi micromètres carrés (1300 µm x 1100 µm) ayant la même structure sous-jacente que dans l'exemple précédent, on obtient une variation d'inductance d'environ un quart (25 %) en cas d'ablation du plan de masse arrière 200.

De façon avantageuse plus la surface de la puce 700 occupé par l'enroulement ou les ondulations du premier élément conducteur et l'autre élément conducteur est importante, plus la variation d'inductance est marquée.

Les connexions permettant d'amener le courant d'excitation aux bornes 71 et 74 du serpentin du premier élément conducteur 70 et de mesurer les paramètres électriques de ce serpentin d'inductance 70 peuvent être réalisées à travers une ou deux couches d'isolation/passivation 80 par l'intermédiaire de via ramenant les bornes de contact S, G, D des transistors T et autres éléments composant le circuit électronique interne de la puce à la surface.

L'avantage de l'invention est que l'autre élément conducteur 200, disposé côté inférieur du substrat 100 pour protéger la face arrière contre des intrusions ou des attaques pirates, ne nécessite pas d'être relié au circuit électronique interne de la puce.

De façon avantageuse, le couplage inductif ou électromagnétique entre le premier élément, qui protège la face avant, et l'autre élément conducteur, qui protège la face arrière, s'effectue à distance sans contact, ce qui permet de s'affranchir du problème de connexion entre le circuit électronique implanté en surface supérieure du substrat 100 et le côté inférieur de la puce correspondant à la face arrière B.

Ainsi, la puce ne comporte pas de via aménagé côté inférieur en face arrière. Aucun via ne traverse le substrat semi-conducteur 100 grâce à l'invention.

Selon le principe exposé précédemment, la disposition d'un premier élément conducteur 30 ou 70 en forme de bobinage d'inductance en face avant A, côté supérieur de la puce, et d'un autre élément conducteur 200 formé d'un plan métallisé en face arrière de l'autre côté du substrat 100, permet d'obtenir un couplage inductif ou électromagnétique entre les éléments conducteurs des faces opposées A et B.

A ce titre, diverses formes et variantes de réalisation peuvent être envisagées pour constituer les éléments conducteurs des deux faces du circuit intégré selon l'invention.

Dans les modes de réalisation exposés précédemment, l'élément conducteur côté inférieur est formé par un plan métallisé. Une telle surface métallisée permet avantageusement de former une masse métallique dans le champ géométrique, et plus précisément dans l'espace ou se propage le champ inductif ou le champ électromagnétique généré par l'inductance du premier élément conducteur.

Ainsi, l'autre élément conducteur forme un plan de masse ou une surface équipotentielle qui s'interpose dans le champ du premier élément conducteur.

De façon avantageuse, un tel plan de masse présente une résistance la plus réduite possible ou une conductance maximale ou du moins particulièrement élevée.

D'après une proposition avancée pour expliquer le phénomène à la base de l'invention, l'excitation de la self-inductance du premier élément conducteur 30 ou 70 induit un champ électromagnétique B qui fait apparaître un fort courant dans le plan de masse faiblement résistant formé par l'autre élément conducteur 200, lequel s'oppose à ce champ, ce qui revient à diminuer la valeur d'inductance du premier élément conducteur 30 ou 70.

Selon une autre forme de réalisation, le premier élément conducteur 10 et par extension, le deuxième élément conducteur 20, peuvent être constitués simplement d'une boucle de circuit s'étendant à la surface ou dans un plan sous la surface supérieure de la puce.

De façon générale, le premier élément conducteur 10, ainsi que le deuxième élément conducteur 20 peut être formé par une seule ou plusieurs pistes conductrices, de préférence métalliques et longilignes, s'étendant à la surface ou dans un plan inclus sous la surface du boîtier de la puce. Cette ou ces pistes peuvent être connectés à une seule de leurs extrémités pour recevoir le signal d'excitation.

Ainsi, selon une autre alternative, le premier élément conducteur et/ou le deuxième élément conducteur peut comporter plusieurs tronçons de pistes disposés de manière sensiblement parallèles et interconnectés bout à bout (cas du serpentin) ou par une seule extrémité en forme de peigne.

Le premier élément conducteur et le deuxième élément conducteur peuvent ainsi avoir des motifs alternés, entremêlés ou entrelacés.

L'autre élément conducteur en face arrière peut également prendre diverses formes pour réaliser la fonction de réflecteur d'antenne électromagnétique, la fonction d'écran et/ou de plan de masse.

L'élément conducteur en face arrière peut ainsi avoir le même motif ou une forme analogue au premier élément conducteur qui constitue l'antenne émettrice sur la première face.

Pour constituer un bon réflecteur, l'élément conducteur en face arrière a de préférence une bonne conductivité ou une faible résistance, comme un plan de masse.

Cet élément conducteur arrière peut être formé d'une armature conductrice, ou d'un enroulement spiral court-circuité, ou d'un serpentin court-circuité, ou d'une boucle de circuit court-circuitée, ou d'une seule piste conductrice ou de plusieurs pistes métalliques parallèles interconnectées.

Selon d'autres formes de réalisation, l'élément conducteur 10 de la face arrière est formé par un motif de maillage conducteur.

L'élément conducteur 10 de la face arrière peut ainsi comporter un réseau de mailles métalliques à maille circulaire ou polygonale, notamment hexagonale ou carrée.

En particulier, l'élément 10 en face arrière, peut être une grille métallique, notamment un réseau de grille en aluminium déposé sur la face arrière du substrat. Le nombre de mailles du réseau peut varier d'une seule maille (une boucle conductrice court-circuitée) à un nombre quelconque de mailles. Plus le nombre de mailles est grand, plus le maillage est serré et constitue une barrière de protection d'efficacité renforcée à l'intrusion d'une sonde ou à l'analyse aux rayons X ou au microscope à balayage électronique.

Par suite, d'autres formes, variantes et modes de réalisation pourront être mis en oeuvre par l'homme de métier, sans sortir du cadre de la présente invention.

## Revendications

1. Dispositif électronique comportant une puce (300) de circuit intégré destiné à contenir ou traiter des données d'information à protéger de manière sécurisée, un premier côté (A) de la puce comportant au moins un premier élément conducteur (30) connecté au circuit intégré, et un autre côté (B) de la puce comportant un autre élément conducteur (200), le premier élément conducteur (30) et l'autrè élément conducteur (200) étant couplés par couplage inductif, l'autre élément conducteur n'étant pas connecté.

2. Dispositif selon la revendication 1, **caractérisé en ce que** le premier côté (A) de la puce comporte, en outre, un deuxième élément conducteur (40) disposé à proximité du premier élément conducteur (30) et/ou relié en série (39) avec le premier élément conducteur (30).

3. Dispositif selon la revendications 2, **caractérisé en ce que** le premier élément conducteur (30) et le deuxième élément conducteur (40) comportent des motifs alternés entremêlés, enroulés ou entrelacés.

4. Dispositif selon l'une des revendications 1 à 3, **caractérisé en ce que** le premier élément conducteur (30) présente une armature émettrice.

5. Dispositif selon l'une des revendications 1 à 4, **caractérisé en ce que** le premier élément conducteur (30) et/ou le deuxième élément conducteur (40) comporte une inductance.

6. Dispositif selon l'une des revendications 1 à 5, **caractérisé en ce que** l'autre élément conducteur (200) comporte une conductance ou une faible résistance de plan de masse.

7. Dispositif selon l'une des revendications 1 à 6, **caractérisé en ce qu'**il comporte des moyens d'excitation électromagnétique du premier élément conducteur.

8. Dispositif selon l'une des revendications 1 à 7, **caractérisé en ce que** le circuit électronique intégré comporte des moyens de mesure de l'inductance d'au moins un des éléments conducteurs et/ou de détection de variation de l'inductance.

9. Dispositif selon la revendication 8, **caractérisé en ce qu'**il comporte des moyens pour effacer ou cesser de stocker les données d'information en cas de détection de changement de valeur de l'inductance.

10. Dispositif selon l'une des revendications 1 à 9, **caractérisé en ce que** le premier élément conducteur (30) et/ou le deuxième élément conducteur (40) est relié au circuit électronique intégré (T) à l'intérieur de la puce (100, 500), tandis que l'autre élément conducteur (200) n'est pas relié.

11. Dispositif selon l'une des revendications 1 à 10, **caractérisé en ce que** la puce (500) comporte des couches supérieures de revêtement (50, 60, 80) comprenant au moins un niveau (52-62, 58-68) métallique ou conducteur permettant de relier le premier élément conducteur (30) avec le circuit électronique intégré (T,100) et/ou avec le deuxième élément conducteur (40).

12. Dispositif selon l'une des revendications 1 à 11, **caractérisé en ce que** le premier et/ou le deuxième élément conducteur (30/40) forme une boucle de circuit.

13. Dispositif selon l'une des revendications 1 à 12, **caractérisé en ce que** l'autre élément conducteur (200) forme un plan de masse ou une équipotentielle.

14. Dispositif selon l'une des revendications 1 à 13, **caractérisé en ce que** le premier et/ou le deuxième élément conducteur (30/40) comporte au moins une piste métallique longiligne (32/42).

15. Dispositif selon l'une des revendications 1 à 14, **caractérisé en ce que** le premier et/ou le deuxième élément conducteur (30/40) comporte plusieurs tronçons interconnectés (32,33,34/42,43,44) disposés de manière sensiblement concentrique, de façon à former une grecque ou une spirale polygonale ou à former une spirale sensiblement circulaire.

16. Dispositif selon l'une des revendications 1 à 15, **caractérisé en ce que** le premier élément et/ou le deuxième élément conducteur (70) comporte plusieurs tronçons interconnectés (71,72,73,74) disposés de manière sensiblement parallèles de façon à former au moins un méandre ou un serpentin.

17. Dispositif selon l'une des revendications 1 à 16, **caractérisé en ce que** l'autre élément (200) comporte un plan ou une portion de surface métallisée ou un réseau de mailles conductrices, notamment un réseau à mailles sensiblement circulaires, carrées, hexagonales ou polygonales, ou une grille.

18. Dispositif selon l'une des revendications 1 à 17, **caractérisé en ce que** chaque élément conducteur (30,40,70,200) est inscrit dans un plan sensiblement parallèle à la surface de côté (A, B) de la puce.

19. Dispositif selon l'une des revendications 1 à 18, **caractérisé en ce que** les éléments conducteurs (30,40,70,200) de la puce sont recouverts d'un matériau d'encapsulation.

20. Carte à puce, **caractérisée en ce qu'**elle comprend au moins un dispositif électronique selon l'une des revendications 1 à 19.

21. Dispositif de cryptage ou de décodage **caractérisé en ce qu'**il comprend un ou plusieurs dispositifs électroniques selon l'une des revendications 1 à 19.

## Claims

1. Electronic device comprising an integrated circuit chip (300) intended to contain or process informative data needing to be securely protected, a first side (A) of the chip comprising at least one first conductive element (30), and another side (B) of the chip comprising another conductive element (200), the first conductive element (30) and the other conductive element (200) being coupled.

2. Device according to claim 1, **characterised in that** the first side (A) of the chip comprises, additionally, a second conductive element (40) arranged in proximity to the first conductive element (30) and/or connected in series (39) with the first conductive element (30).

3. Device according to claim 2, **characterised in that** the first conductive element (30) and the second conductive element (40) comprise alternate intermingled, wound or intertwined patterns.

4. Device according to one of claims 1 to 3, **characterised in that** the first conductive element (30) has a transmitting armature.

5. Device according to one of claims 1 to 4, **characterised in that** the first conductive element (30) and/or the second conductive element (40) comprises an inductance.

6. Device according to one of claims 1 to 5, **characterised in that** the other conductive element (200) comprises an earth plane conductance or a low resistance.

7. Device according to one of claims 1 to 6, **characterised in that** it comprises means for the electromagnetic excitation of the first conductive element.

8. Device according to one of claims 1 to 7, **characterised in that** the integrated electronic circuit comprises means for measuring the inductance of at least one of the conductive elements and/or for detecting variation in the inductance.

9. Device according to claim 8, **characterised in that** it comprises means for deleting or ceasing to store the informative data in the event of a change being detected in the value of the inductance.

10. Device according to one of claims 1 to 9, **characterised in that** the first conductive element (30) and/or the second conductive element (40) is connected to the integrated electronic circuit (T) inside the chip (100, 500), whereas the other conductive element (200) is not connected.

11. Device according to one of claims 1 to 10, **characterised in that** the chip (500) comprises upper coating layers (50, 60, 80) including at least one metal or conductive level (52-62, 58-68) allowing the first conductive element (30) to be connected with the integrated electronic circuit (T, 100) and/or with the second conductive element (40).

12. Device according to one of claims 1 to 11, **characterised in that** the first and/or the second conductive element (30/40) forms a circuit loop.

13. Device according to one of claims 1 to 12, **characterised in that** the other conductive element (200) forms an earth plane or an equipotential.

14. Device according to one of claims 1 to 13, **characterised in that** the first and/or the second conductive element (30/40) comprises at least one longilinear metal track (32/42).

15. Device according to one of claims 1 to 14, **characterised in that** the first and/or the second conductive element (30/40) comprises several interconnected sections (32, 33, 34/42, 43, 44) arranged in a substantially concentric way, so as to form a corrugation or a polygonal spiral or to form a substantially circular spiral.

16. Device according to one of claims 1 to 15, **characterised in that** the first element and/or the second conductive element (70) comprises several interconnected sections (71, 72, 73, 74) arranged in a substantially parallel way so as to form at least one meander or one coil.

17. Device according to one of claims 1 to 16, **characterised in that** the other element (200) comprises a plane or a metal plated surface portion or a network of conductive meshes, particularly a network of substantially circular, square, hexagonal or polygonal meshes, or a grid.

18. Device according to one of claims 1 to 17, **characterised in that** each conductive element (30, 40, 70, 200) lies in a plane substantially parallel to the side surface (A, B) of the chip.

19. Device according to one of claims 1 to 18, **characterised in that** the conductive elements (30, 40, 70, 200) of the chip are coated with an encapsulation material.

20. Chip card, **characterised in that** it includes at least one electronic device according to one of claims 1 to 19.

21. Encryption or decoding device **characterised in that** it includes one or more electronic devices according to one of claims 1 to 19.

## Patentansprüche

1. Elektronische Vorrichtung mit einem IC-Chip (300), dazu bestimmt, zu schützende Informationsdaten auf sichere Weise zu speichern oder zu verarbeiten, wobei eine erste Seite (A) des Chips wenigstens ein mit der integrierten Schaltung verbundenes erstes leitendes Element (30) umfasst, und eine andere Seite (B) des Chips ein anderes leitendes Element (200) umfasst, und das erste leitende Element (30) und das andere leitende Element (200) durch induktive Kopplung gekoppelt sind, wobei das andere leitende Element nicht verbunden ist.

2. Vorrichtung nach Anspruch 1, **dadurch gekennzeichnet, dass** die erste Seite (A) des Chips außerdem ein zweites leitendes Element (40) umfasst, angeordnet in der Nähe des ersten leitenden Elements (30) und/oder mit dem ersten leitenden Element (30) in Reihe geschaltet (39).

3. Vorrichtung nach Anspruch 2, **dadurch gekennzeichnet, dass** das erste leitende Element (30) und das zweite leitende Element (40) abwechselnd miteinander vermischte, gewickelte oder verschlungene Muster umfassen.

4. Vorrichtung nach einem der Ansprüche 1 bis 3, **dadurch gekennzeichnet, dass** das erste leitende Element (30) eine Sendearmierung (armature émettrice) aufweist.

5. Vorrichtung nach einem der Ansprüche 1 bis 4, **dadurch gekennzeichnet, dass** das erste leitende Element (30) und/oder das zweite leitende Element (40) eine Induktivität umfasst.

6. Vorrichtung nach einem der Ansprüche 1 bis 5, **dadurch gekennzeichnet, dass** das andere leitende Element (200) eine Konduktanz oder einen niedrigen Masseebenenwiderstand umfasst.

7. Vorrichtung nach einem der Ansprüche 1 bis 6, **dadurch gekennzeichnet, dass** sie elektromagnetische Erregungseinrichtungen des ersten leitenden Elements umfasst.

8. Vorrichtung nach einem der Ansprüche 1 bis 7, **dadurch gekennzeichnet, dass** die integrierte elektronische Schaltung Einrichtungen zum Messen der Induktivität von wenigstens einem der leitenden Elemente und/oder zum Detektieren der Induktivitätsveränderung umfasst.

9. Vorrichtung nach Anspruch 8, **dadurch gekennzeichnet, dass** sie Einrichtungen umfasst, um im Falle der Detektion einer Veränderung des Werts der Induktivität die Informationsdaten zu löschen oder nicht mehr einzuspeichern.

10. Vorrichtung nach einem der Ansprüche 1 bis 9, **dadurch gekennzeichnet, dass** das erste leitende Element (30) und/oder das zweite leitende Element (40) mit der integrierten elektronischen Schaltung (T) im Innern des Chips (100,500) verbunden ist, während das andere leitende Element (200) nicht verbunden ist.

11. Vorrichtung nach einem der Ansprüche 1 bis 10, **dadurch gekennzeichnet, dass** der Chip (500) obere Überzugsschichten (50,60,80) umfasst, die wenigstens ein metallisches oder leitendes Niveau (52-62,58-68) aufweisen, das ermöglicht, das erste leitende Element (30) mit der integrierten elektronischen Schaltung (T,100) und/oder mit dem zweiten leitenden Element (40) zu verbinden.

12. Vorrichtung nach einem der Ansprüche 1 bis 11, **dadurch gekennzeichnet, dass** das erste und/oder das zweite leitende Element (30/40) eine Schaltungsschleife bilden.

13. Vorrichtung nach einem der Ansprüche 1 bis 12, **dadurch gekennzeichnet, dass** das andere leitende Element (200) eine Masseebene oder ein Äquipotential bildet.

14. Vorrichtung nach einem der Ansprüche 1 bis 13, **dadurch gekennzeichnet, dass** das erste und/oder zweite leitende Element (30/40) wenigsten eine langgliedrige metallische Bahn (32/42) umfasst.

15. Vorrichtung nach einem der Ansprüche 1 bis 14, **dadurch gekennzeichnet, dass** das erste und/oder zweite leitende Element (30/40) mehrere miteinander verbundene, im Wesentlichen konzentrisch angeordnete Abschnitte (32,33,34/42,43,44) umfasst, die einen Mäander bzw. etwas Mäanderartiges (une grecque) oder eine polygonale Spirale oder eine im Wesentlichen kreisförmige Spirale bilden.

16. Vorrichtung nach einem der Ansprüche 1 bis 15, **dadurch gekennzeichnet, dass** das erste und/oder zweite leitende Element (70) mehrere miteinander verbundene, im Wesentlichen parallel angeordnete Abschnitte (71,72,73,74) umfasst, die einen Mäander oder eine Schlange bilden.

17. Vorrichtung nach einem der Ansprüche 1 bis 16, **dadurch gekennzeichnet, dass** das andere Element (200) eine Ebene oder ein Teilstück einer metallisierten Fläche oder ein Netz oder Gitter aus leitfähigen Maschen umfasst, insbesondere ein Netz oder Gitter aus im Wesentlichen kreisförmigen, quadratischen, hexagonalen oder polygonalen Maschen.

18. Vorrichtung nach einem der Ansprüche 1 bis 17, **dadurch gekennzeichnet, dass** jedes leitende Element (30,40,70,200) sich in einer Ebene befindet, die im Wesentlichen parallel ist zu der Seitenoberfläche (A,B) des Chips.

19. Vorrichtung nach einem der Ansprüche 1 bis 18, **dadurch gekennzeichnet, dass** die leitenden Elemente (30,40,70,200) des Chips mit einem Einkapselungsmaterial überzogen sind.

20. Chip-Karte, **dadurch gekennzeichnet, dass** sie wenigstens eine elektronische Vorrichtung nach einem der Ansprüche 1 bis 19 umfasst.

21. Verschlüsselungs- oder Decodiervorrichtung, **dadurch gekennzeichnet, dass** sie eine oder mehrere elektronische Vorrichtungen nach einem der Ansprüche 1 bis 19 umfasst
